# EUROPEAN PATENT SPECIFICATION

(11) **EP 0 350 932 B1**
(45) Date of publication and mention of the grant of the patent: **10.04.1996**
(21) Application number: 89112875.3
(22) Date of filing: 13.07.1989
(51) Int. Cl.: G06F 3/05, G06F 17/40, H03M 1/12

(54) **One-chip data processor with built-in A/D converter**
Ein-Chip-Datenprozessor mit eingebautem A/D-Wandler
Processeur de données monopuce à convertisseur analogique-numérique incorporé

(30) Priority: 13.07.1988 JP 175806/88
(43) Date of publication of application: 17.01.1990
(73) Proprietor: NEC CORPORATION, Tokyo (JP)
(72) Inventor: Abe, Hideo c/o NEC Corporation, Minato-ku Tokyo (JP)
(74) Representative: Glawe, Delfs, Moll & Partner

(56) References cited:
- ELECTRONIC DESIGN vol. 35, no. 5, 5 March 1987, HASBROUCK HEIGHTS, NJ, USA pages 85 - 91; YAGER: 'data-acquisition system fits on a smart peripheral chip'
- ELECTRONICS & WIRELESS WORLD vol. 93, no. 1620, October 1987, SUTTON SURREY GR.BRITAIN pages 1013 - 1017; YAGER ET AL: 'single-chip data acquisition subsystem'
- ELECTRONIQUE INDUSTRIELLE no. 20, May 1988, PARIS FRANCE pages 28 - 33; CRESCENZO: "microcontroleur 16 bits"

## Description

### FIELD OF THE INVENTION

This invention relates to a one-chip data processor such as a microprocessor or a microcomputer and, more particularly, to a built-in A/D (analog-to-digital) converter circuit fabricated on the same semiconductor chip.

### DESCRIPTION OF THE RELATED ART

The device dimension has been scaled down by virtue of the progressive improvement in the manufacturing techniques, and, accordingly, the component elements per chip has been increased in number. Then, a complex circuit is realized on a single semiconductor chip, and a semiconductor chip tends to be shared by peripheral circuits and a microprocessor. For example, an A/D converter circuit is a popular and important peripheral circuit in the automotive usage as well as a servomechanism, and is frequently provided in association with a microprocessor for controlling the mechanism. Thus, the A/D converter circuit is combined with the microprocessor in various applications, and a one-chip microprocessor with built-in A/D converter circuit is developed for those applications.

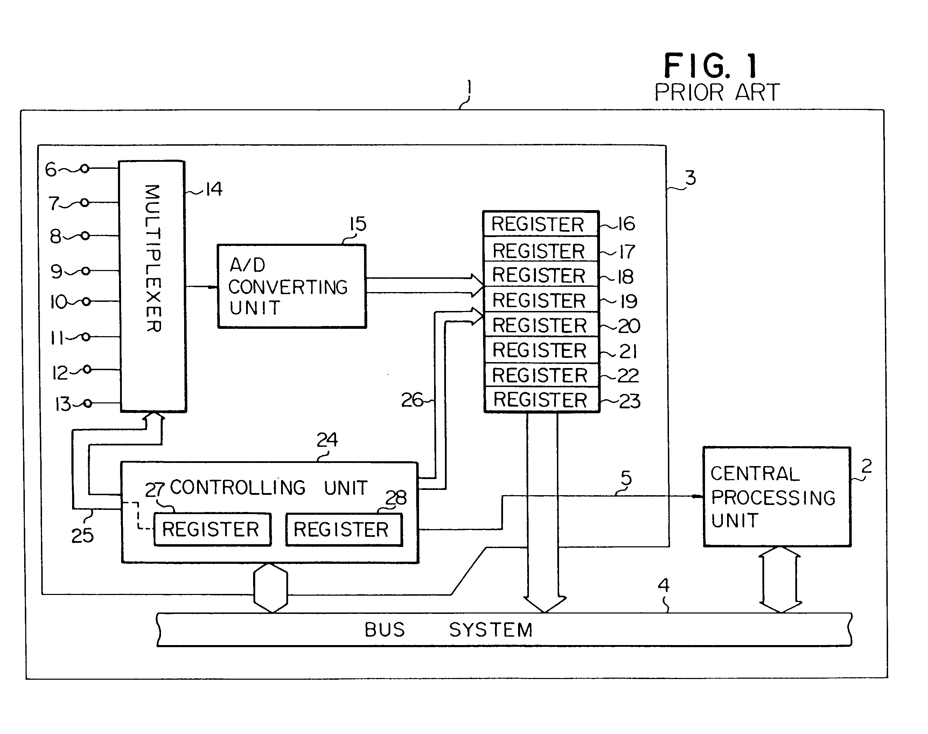

Fig. 1 shows a typical example of the one-chip microprocessor with built-in A/D converter circuit. A semiconductor chip 1 is shared by a central processing unit 2 and an A/D converter circuit 3 which are communicable with each other through an internal bus system 4. The central procesing unit 2 sequentially fetches programed instruction codes and excutes them for data processing upon data supplied from or to the A/D converter circuit, and the A/D converter circuit 3 drives an interrupt signal line 5 for requesting an interrupt service routine.

The A/D converter circuit 3 largely comprises a plurality of input nodes 6, 7, 8, 9, 10, 11, 12 and 13, an analog multiplexer 14, an A/D converting unit 15, a plurality of registers 16, 17, 18, 19, 20, 21, 22 and 23, and a controlling unit 24. The input nodes 6 to 13 are coupled in parallel to outside signal generators (not shown) such as sensor units which independently produce analog voltage signals. The analog multiplexer is responsive to a multiple-bit selecting signal on signal lines 25, and is transparent to one of the analog voltage signals. The analog voltage signal passing through the analog multiplexer 14 is supplied to the A/D converting unit 15, and is, then, converted into a digital signal which is tantamount in value to the analog voltage signal. The digital signal thus produced is supplied to one of the registers 16 to 23 assigned by an address signal on address signal lines 26, and is memorized thereinto. When the predetermined A/D converting operations are completed, the controlling unit 24 produces an interrupt requesting signal which is transferred through the interrupt signal line 5 to the central processing unit 2. With the interrupt requesting signal, the central processing unit 2 is branched to the interrupt service routine, and fetches the data bits memorized in the registers 16 to 23 in the digital form for processing.

Thus, the controlling unit 24 not only provides a timing for the interrupt service routine but also supervises the multiplexer 14 associated with the A/D converting unit 15 and the registers 16 to 23, and, for this purpose, is provided with two registers 27 and 28. The register 27 is used for producing the selecting signal, and a node-selection coded is stored in the register 27 for steering operation on the multiplexer 14. On the other hand, the register 28 stores a function code which defines the function of the A/D converter circuit 3. Both of the registers 27 and 28 are accessible for the central processing unit 2, and, accordingly, the node-selecting code and the function code are supplied from the central processing unit 2 to the registers 27 and 28, respectively.

The A/D converter circuit 3 usually has two modes of operation, i.e., a fixed mode of operation and a scanning mode of operation depending upon the function code. In the fixed mode of operation, the node-selecting code is fixedly stored in the register 27 throughout the operation, and, for this reason, the multiplexer 14 transfers an analog voltage signal on the input node specified by the node selecting code to the A/D converting unit 15. On the other hand, the node-selecting code is periodically changed so as to scan the input nodes 6 to 13 in the scanning mode of operation, and the multiplexer 14 is sequentially transparent for all of the input nodes 6 to 13, thereby allowing all of the analog voltage signals to be supplied to the A/D converting unit 15. These two modes of operation are directly related to the starting point of the present invention, so that description is hereinbelow made for the fixed mode of operation as well as the scanning mode of operation under the separate sub-titles.

### Fixed Mode of Operation

When the function code has value "0", the fixed mode of operation is established in the A/D converter circuit 3, and, accordingly, the A/D converting unit 15 continuously converts the analog voltage signal on one of the input nodes 6 to 13 specified by the node-selecting code in the register 27. The value of the node-selecting code indicates the location of the specified input node. Namely, when the node selecting code has value of "5", the multiplexer 14 transfers the analog voltage signal on the input node 11 to the A/D converting unit 15, however, if value of "7" is assigned to the node-selecting code, the analog voltage signal on the input node 13 passes through the multiplexer 14 and reaches the A/D converting unit 15. After the A/D conversion, the digital signal is supplied to one of the registers 16 to 23. Since the registers 16 to 23 are associated with the input nodes 6 to 13, respectively, the digital signal is memorized in the associated register. For example, when the input node 11 is specified by the node-selecting code, the digital signal is stored in the register 21, however, if the input node 13 is selected by the code, the register 23 is continuously used for the digital signal.

Thus, the A/D converting unit 15 fixes the converting operation to one of the analog voltage signals, and produces a series of the digital signals. As described hereinbefore, only one associated register is used for the digital signals, and, for this reason, the controlling unit 24 periodically produces the interrupt requesting signal after the completion of every single A/D converting operation.

### Scanning Mode of Operation

The scanning mode of operation is representative of the function code of "1", and the A/D converting unit 15 repeats the A/D converting operation for the input nodes 6 to 13.

In detail, the scanning mode of operation starts with memorizing the function code of "1" supplied from the central processing unit 2. Whenever the scanning mode of operation is established in the A/D converter circuit 3, the node-selecting code supplied from the central processing unit 2 is made invalid, and the controlling unit 24 sequentially supplies the multiplexer 14 with the selecting signals for steering the analog voltage signals on the input nodes 6 to 13. Namely, the analog voltage signal on the input node 6 is firstly transferred to the A/D converting unit 15 to produce a digital signal, and the digital signal is relayed to the register 16. Next, the multiplexer 14 becomes transparent for the analog voltage signal on the input node 7, so that the analog voltage signal is converted into a digital signal by the A/D converting unit 15, then memorizing the digital signal into the register 17. In this manner, the controlling unit 24 sequentially requests the multiplexer 14 to transfer all of the analog voltage signals to the A/D converting unit 15, and the A/D converting unit 15 repeats the A/D converting operation for filling the registers 16 to 23 with the digital signals. When the A/D converting operation is completed for the analog voltage signal on the input node 13, the controlling unit 24 produces the interrupt requesting signal, and the interrupt signal line 5 propagates the requesting signal to the central processing unit 2. However, no job is assigned to the central processing unit 2 upon the receipt of the interrupt requesting signal, and, for this reason, the interrupt requesting signal is masked in the central processing unit 2. After the completion of a set of the A/D converting operations is reported by the interrupt requesting signal, the controlling unit 24 causes the multiplexer 14 to return to the analog voltage signal of the input node 6.

In the practical operation, the fixed mode of operation is mixed with the scanning mode of operation. Assuming now that the A/D converter circuit remains in the scanning mode of operation, the controlling unit 24 allows the multiplexer 14 to sequentially transfer the analog voltage signals on the input nodes 6 to 13 for producing the digital signal or the digital codes, and the digital codes are memorized in the registers 16 to 23, respectively. However, while sequentially executing the programmed instructions, an A/D conversion sub-routine call takes place, and the central processing unit 2 needs to fetch one of the latest digital data codes stored in the registers 16 to 23. The central processing unit 2 writes the function code of "0" into the register 28, and, then, the register 27 is, by way of example, supplied with the node-selecting code representative of one of the input nodes 6 associated with the necessary digital code. With the function code of "0", the A/D converter circuit 3 is shifted to the fixed mode of operation, and the multiplexer 14 transfers the analog voltage signal on the input node 6 to the A/D converting unit 15. The analog voltage signal is converted to the digital code, and is relayed to the register 16 as the latest data code. When the digital code is memorized in the register 16, the interrupt requesting signal is supplied from the controling unit 24 to the central processing unit 2. With the interrupt requesting signal, the central processing unit 2 fetches the digital code in the register 16, and executes programmed instructions for the latest digital code. Thus, the central processing unit 2 does not mask the interrupt requesting signal, and repeats the data fetch certain times. After this, the central processing unit 2 puts the function code of "1" in the register 28, and, for this reason, the A/D converter circuit 3 returns to the scanning mode of operation. In the scanning mode of operation, the central processing unit 2 masks the interrupt requesting signal again. The masked state and the non-masked state should be alternatively established in the central processing unit 2.

The prior art article "ELECTRONICS AND WIRELESS WORLD, vol. 93, n° 1620, Oct. 1987, Sutton (Surrey), GB; p. 1013 - 1017; YAGER et al. : Single-chip data acquisition subsystem" describes such a data processor with a built-in analog-to-digital converter; it comprises
a) a central processing unit,
b) a plurality of analog input nodes,
c) analog input selecting means,
d) an analog-to-digital converting unit
e) a plurality of registers, and
f) an analog-to-digital converting unit

Once the conversion has been initialized, it runs autonomously without instruction from the central processing unit and converts the analog signals at all analog input nodes. However, the result of the A/D conversion is stored in a RAM and the microprocessor needs to supply a command to the subsystem in order to cope with a conversion transition.

A problem is encountered in the prior art microprocessor with the built-in A/D converter in a relatively low throughput. This is because of the fact that the central processing unit is involved in the establishment of both operation modes. Namely, when the A/D converter circuit 3 is shifted between the fixed mode of operation and the scanning mode of operation, the central processing unit 2 provides the function code representative of the new mode of operation. Moreover, since the masked state is established in the scanning mode of operation but the mask should be removed from the interrupt requesting signal in the fixed mode of operation. These jobs consume a substantial amount of time period, and, for this reason, the throughput is deteriorated in the central processing unit 2.

### SUMMARY OF THE INVENTION

It is therefore an important object of the present invention to provide a one-chip microprocessor with built-in A/D converter which is improved in throughput.

It is also important object of the present invention to provide a one-chip microprocessor with built-in A/D converter which automatically returns to the scanning mode of operation.

To accomplish these objects, the present invention proposes to provide a third mode of operation for repeating the fixed mode of operation a predetermined number of times before automatically returning to the scanning mode of operation.

In accordance with the present invention, there is provided a data processor fabricated on a single semiconductor chip with a built-in an analog-to-digital converter circuit as claimed in claim 1.

### BRIEF DESCRIPTION OF THE DRAWINGS

The features and advantages of a one-chip microprocessor with built-in A/D converter according to the present invention will be more clearly understood from the following description taken in conjunction with the accompanying drawings in which:
Fig. 1 is a block diagram showing the circuit arrangement of a prior art one chip microprocessor with a built-in A/D converter;
Fig. 2 is a block diagram showing the circuit arrangement of a one-chip microprocessor with a built-in A/D converter embodying the present invention;
Fig. 3 is a circuit diagram representative of a controlling unit shown in Fig. 3; and
Fig. 4 is a circuit diagram representative of an A/D conversion controlling unit according to another embodiment of the present invention.

### DESCRIPTION OF THE PREFERRED EMBODIMENTS

### First embodiment

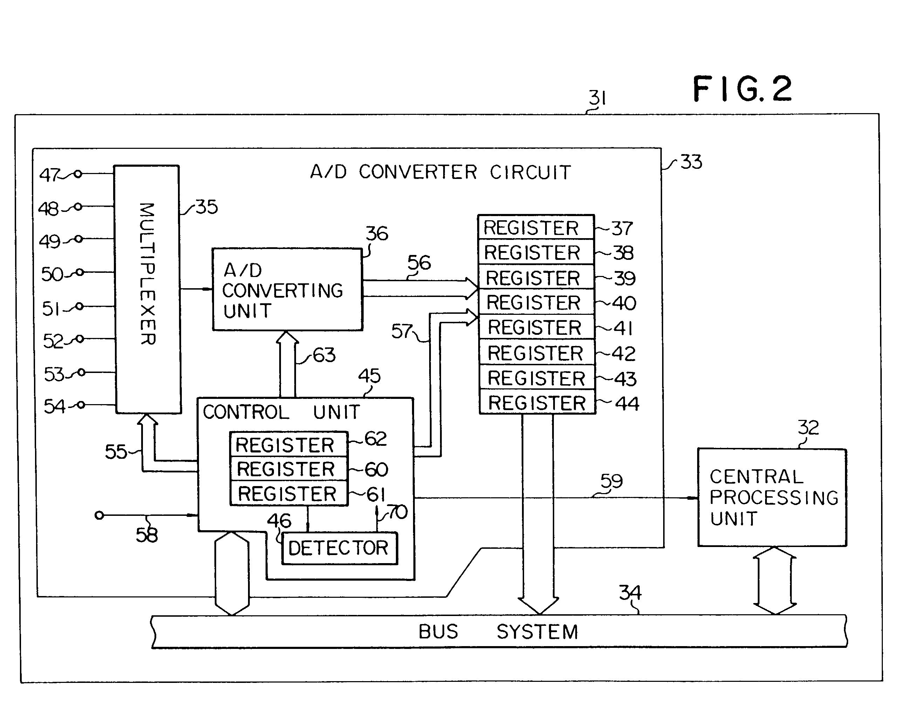

Referring first to Fig. 2 of the drawings, a microprocessor with a built-in A/D converter is fabricated on a single semiconductor chip 31. The microprocessor largely comprises a central processing unit 32 and an A/D converter circuit 33 communicable with each other through a multiple-bit bus system 34. The central processing unit 32 is well known in the art, so that no further description is incorporated in the following description. The A/D converter circuit 33 comprises a multiplexer 35, an A/D converting unit 36, a plurality of registers 37, 38, 39, 40, 41, 42, 43 and 44, and a controlling unit 45. The A/D converter circuit 33 is shiftable between a fixed mode of operation and a scanning mode of operation, and both of the operation modes re similar to those of the prior art microprocessor shown in Fig. 1.

The multiplexer 35 is associated with a set of input nodes 47, 48, 49, 50, 51, 52, 53 ad 54, and steers analog voltage signals on the input nodes 47 to 54 in response to a selecting signal on selecting signal lines 55. The A/D converting unit 36 is coupled to the registers 37 to 44 through a multiple-bit bus 56 and converts the analog voltages into corresponding digital data bits in response to timing signals suplied from the unit 45 via timing signal lines 63. The converted digital data bits are transferred to the corresponding registers 37 to 44 and memorized therein. The registers 37 to 44 are provided in association with the input nodes 47 to 54, respectively, and the digital signals are assigned to the registers 37 to 44 by an address signal supplied from the controlling unit 45 through an address bus 57. Namely, when the selecting signal, by way of example, specifies the input node 47, the digital data bits are transferred from the A/D converting unit 36 to the register 37, however, if the input node 48 is selected by the signal, the address signal assigns the register 38 to the digital data bits converted from the analog voltage signal on the input node 48. The control unit 45 is supplied through a signal line 58 with a conversion request signal which will be described later in detail. An interrupt requesting signal is supplied from the controlling unit 45 to the central processing unit 32 through an interrupt signal line 59 upon completion of the A/D converting signal or a cycle of A/D converting operations. The central processing unit 32 are accessible to the digital codes stored in the registers 37 to 44 through the multiple-bit bus system 34.

The controlling unit 45 has two function registers 60 and 61, a node selection register 62, and a detector 46. The node selection register 62 stores a node-selecting code in a rewritable manner, and the selecting signals 55 and 57 are produced on the basis of the node-selecting code.

The function registers 60 and 61 provide a storage for a function code, and the contents thereof are controlled by the central processing unit 32. The detector 46 detects that the value of "1" is written into the function register 61 by comparing with a reference code. The central processing unit 32 is accessible to the node-selecting register 62 as well as the function registers 60 and 61 through the bus system 34.

The A/D converter circuit 33 thus constituted has three kinds of operation modes, which will be described hereinbelow, in accordance with the function codes stored in the function registers 60 and 61.

### In case where both registers 60 and 61 store the function code of "0".

The fixed mode of operation is established in the A/D converter circuit 33, and the multiplexer 35 is transparent for one of the analog signals on the input node specified by the selecting signal 55. Assuming now that the input node 47 is selected by the selecting signal 55 produced on the basis of the node-selecting code stored in the node register 62, the analog voltage signal on the input node 47 is transferred to the A/D converting unit 36. In response to the timing signals 63, the A/D converting unit 36 repeats a series of steps of sampling the analog voltage signal on the node 47, converting the sampled analog voltage into digital data bits, then storing the digital data bits into the corresponding register 37. Whenever the digital data bits are stored into the register 37, the controlling unit 45 activates the interrupt requesting signal 59. The central processing unit 32 is thereby branched to the interrupt service subroutine, so that the digital code in the register 37 is fetched by the central processing unit 32. Thus, the controlling unit 45 focuses the A/D converting unit 36 on the analog voltage signal on the input node 47, and allows the A/D converting unit 36 to repeat the A/D operation on the analog voltage signal.

### In case where the registers 60 and 61 respectively store the function codes of "1" and "0"

The scanning mode of operation is established in the A/D converter circuit 33, and, accordingly, the node-selecting code in the register 62 is ignored.

The multiplexer 35 sequentially transfers the analog voltage signals from the input node 47 to the input node 54, and returns to the input node 47 again for repetition. With the analog voltage signals, the A/D converting unit 36 produces the digital signals which are memorized in the registers 37 to 44 assigned by the address signal, respectively. When one cycle of the A/D converting operations are completed and, accordingly, the digital signals are respectively stored in all of the registers 37 to 44, the controlling unit 45 activates the interrupt requesting signal 75, and allows the multiplexer 35 to sequentially transfer the analog voltage signals on the input nodes 47 to 54 to the A/D converting unit 45. In response to the interrupt requesting signal 75, the central processing unit 32 reads the digital data bits from the registers 37 to 44 through the bus system 34.

### In case where the register 61 stores the function code of "1"

The content of the register 60 is ignored. In response to the register 61 written with the code of "1", the A/D converter circuit performs the fixed mode of operation once and then turns to the scanning mode of operation. However, in this scanning mode, the interrupt request signal 59 is masked, i.e., is not generated. More specifically, when the central processing unit 32 performs an operation of writing the function code of "1" to the function register 61, the detector circuit 46 detects this operation and produces a detecting signal 70 of an active high level. With the detecting signal 70 of the active high level, the controlling circuit 45 allows the A/D converting unit 36 to produce digital data bits responsive to the analog voltage signal on one of the input nodes 47 to 54 specified by the selecting signal 55 responsive to the selection code of the register 62. The digital data bits thus produced are stored into the associated one of the registers 37 to 44, and the controlling unit 45 produces the interrupt requesting signal 59. The digital data bits are thereby fetched by the central processing unit 32 in the interrupt service routine. The A/D converter circuit 33 thereafter turns to the scanning mode of operation, and executes this operation without generating the interrupt requesting signal 59. When the conversion request signal 58 is supplied t the unit 45 from the central processing unit 32 or the outside while the function register 61 stores the function code of "1", the operation mode described above takes place in the A/D converter circuit 33 with the shifting signal of the active high level.

In this manner, when it is necessary to convert the analog voltage signal on a certain input node into the corresponding digital data bits, the central processing unit 32 writes the code representative of the input node into the register 62, and, further, provides the function code of "0" into both of the registers 60 and 61. If, on the other hand, all of the analog voltage signals be periodically converted into the corresponding digital data, respectively, the function code "1" and the function code of "0" are written into the registers 60 and 61, respectively. Moreover, whenever a certain analog voltage signal should be converted into the corresponding digital data bits once, the central processing unit the selecting code indicative of the analog voltage signal is written into the register 62, and the function code of "1" is written into the register 61.

While the central processing unit 32 executes a series of programmed instruction codes, the A/D conversion subroutine call takes place, and a certain analog input voltage signal is requested to be converted into the corresponding digital data code once in the subroutine call. The central processing unit 32 transfers the selecting code indicative of the necessary analog voltage signal to the register 62, and writes the function code "1" into the register 61. However, if the selecting code has been written into the register 62, no selecting code is transferred thereto. Furthermore, it is unnecessary for the central processing unit 32 to mask the interrupt requesting signal 59 and recover therefrom, which are associated with the subroutine call in the prior art system. If the A/D conversion requesting signal 58 is supplied in synchronization with an event outside thereof, the analog voltage signal produced upon the event is automatically converted into the digital data bits in so far as the code "1" has been written into the register 61.

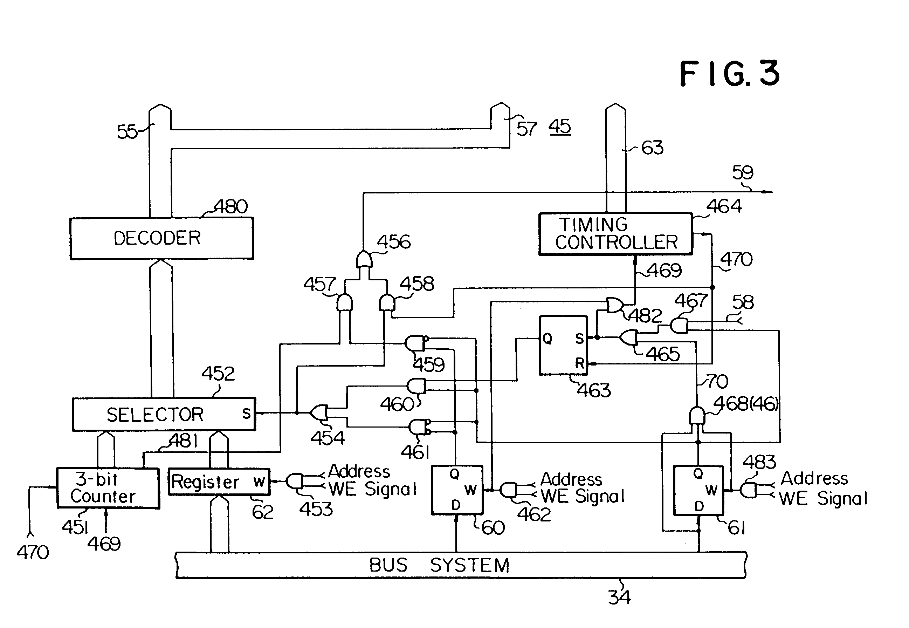

Turning to Fig. 3 of the drawings, the control unit 45 is illustrated in detail. The corresponding component elements are designated by like reference numerals used in Fig. 2 without any detail description. The control unit 45 further comprises a three-bit counter circuit 469, a selector circuit 452, a decoder circuit 480, a timing controller 464, a S-R flip-flop circuit 463, AND gates 453, 457, 458, 459, 460, 461, 462, 467 and 483, OR gates 454, 456, 465 and 482, and an AND gate 468 serving as the detector 46 in Fig. 2, and these circuits are coupled to one another as shown in Fig. 3.

Assuming now that the function code of "0" is written into the registers 60 and 61, the AND gate 461 produces the output signal of "1" level, however, the AND gates 459 and 460 remain in the "0" level. Then, the output signal of "1" level is supplied from the AND gate 461 through the OR gate 454 to the selecting node S of the selector 452. The selector 452 activates the register 62 to transfer the contents thereof to the decoder circuit 480, and the decoded signal is fed from the decoder circuit 480 to the multiplexer 35 and the registers 37 to 44 in Fig. 2.

When the function code of "0" is written into the register 60, the AND gate 462 produces the output signal of "1" level which in turn is supplied via the OR gate 482 to the timing controller 464 as the A/D conversion activation signal 469. THe controller 464 is initialized with the signal 469, and supplies the timing signal to the A/D conversion unit 36 in Fig. 2. The timing controller 464 produces a complete signal 470 upon completion of the single A/D converting operation. The complete signal 470 is supplied to the AND gate 458, and the interrupt requesting signal 59 is produced via OR gate 456, because the OR gate produces the output signal of "1" level. Thus, whenever the function code of "0" are written into the registers 60 and 61, one of the analog signals is selected depending upon the node selecting code stored in the register 62, and is continuously converted into the corresponding digital data bits.

If the function codes of "1" and "0" are respectively written into the registers 60 and 61, the AND gate 459 produces the output signal of "1", the AND gates 460 and 461 produces the respective output signals of "0" level, and, accordingly, the OR gate 454 produces the output signal of "0" level. In this situation, the selector 452 selects the three-bit counter circuit 451. With the reset signal or the activation signal 469 produced upon write-in operation on the register 60, the counter circuit 451 increments the value stored therein with the A/D conversion complete signal 470, and an overflow signal 481 is supplied from the counter circuit 451 to the AND gate 457, and the output signal thereof is suppied to the OR gate 456 to produce the interrupt requesting signal 59. Whenever the function codes of "1" and "0" are written into the registers 60 and 61, all of the analog voltage signals on the respective input nodes 47 to 54 are sequentially converted to the corresponding digital data, and the interrupt requesting signal 59 is produced upon completion of every cycle.

When the function code of "1" is written into the register 61, the AND gate 468 detects the write-in operation, and, then, produces the detecting signal 70. The detecting signal 70 is supplied to the OR gate 465 the output signal of which is used for setting the flip-flop circuit 463 and is further used for initializing the controller 464. Since the flip-flop circuit 463 is shifted to the set-state, the AND gate 460 produces the output signal of "1" level, and, accordingly, the selector circuit 452 selects the register 62. For this reason, the analog voltage signal indicated by the contents of the register 62 is converted to the corresponding digital data bits, and the converted digital data bits are memorized in the corresponding register. Moreover, the conversion complete signal 470 is produced and allows the series combination of the AND gate 458 and the OR gate 456 to produce the interrupt requesting signal 59. The interrupt requesting signal 59 is supplied to the central processing unit 32 of Fig. 2, and the flip-flop is shifted to the reset-state. When the flip-flop 463 is shifted to the reset-state, the AND gate 460 shifts the output signal to the "0" level, and, accordingly, the OR gate 454 shifts the output signal to the "0" level, thereby causing the selector circuit 452 to select the counter circuit 451. As a result, the A/D converter 33 proceeds to the sequential A/D converting operations on all of the analog voltage signals. Upon completion of every A/D converting operation, no interrupt requesting signal 59 is produced even if the complete signal 470 or the overflow signal 481 take place, because the AND gates 457 and 458 are closed. When the A/D conversion requesting signal 58 is supplied thereto in the presence of the function code "1" stored in the register 61, the series combination of the AND gate 467 and the OR gate 465 sets the flip-flop ciruit 463, and, for this reason, the third operation mode is established in the A/D converter.

In this instance, when the third operation mode is established, the analog voltage signal indicated by the node selecting code in the register 62 is converted into the corresponding digital data bits once, however, the analog voltage signal tends to contain unavoidable error and undesirable noises. For eliminating these error and noises, it is desirable to take an average of a plurality of the digital data converted from the same analog voltage signal. In order to take the average, the analog voltage signal should be repeatedly converted into the plural digital data, and this operation mode (the fourth operation mode) is supplemented to another implementation which is described hereinbelow.

### Second embodiment

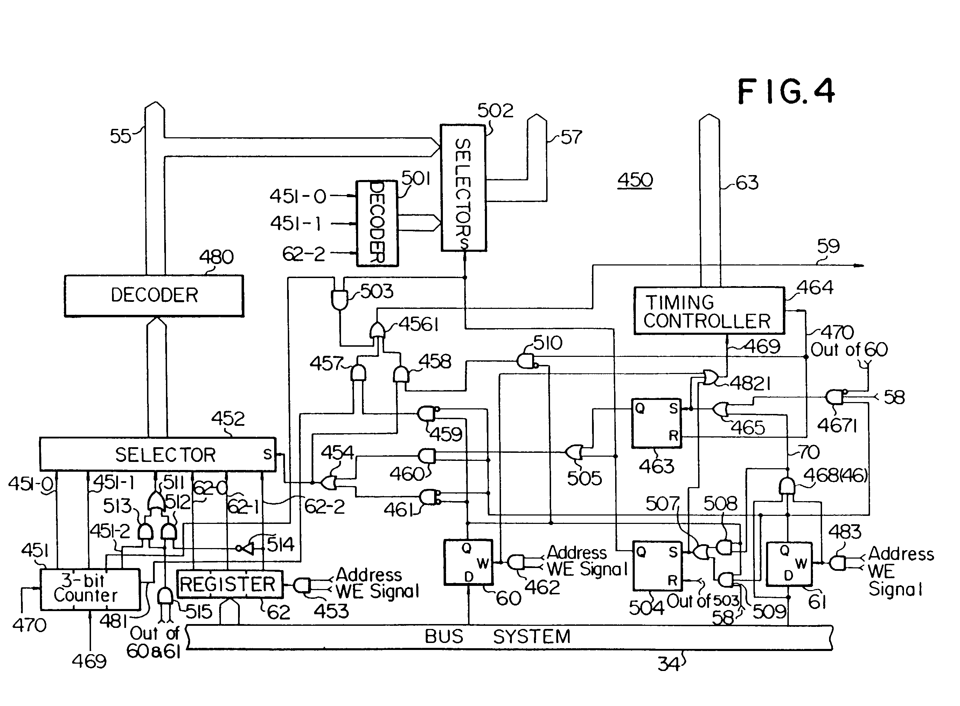

The microprocessor with built-in A/D converter has not only the first to third operation modes but also the fourth operation mode, however, the general arrangement is similar to that illustrated in Fig. 1 except for a control unit 450, so that description is hereinbelow made for the control unit 450 with reference to Fig. 4, but no further description for the other component blocks is incorporated. In Fig. 4, the component circuits and blocks corresponding to those in Figs. 2 and 3 are denoted by like reference numerals for the sake of simplicity.

The control unit 450 shown in Fig. 4 comprises a decoder 501, a selector 502, a S-R flip-flop circuit 504, AND gates 508, 509, 510, 512, 513 and 515, OR gates 507 and 511, and inverter circuit 514, and these component circuits are arranged to be coupled to one another as shown in Fig. 4. The decoder 501 is supplied with the two lower order bits 451-0 and 451-1 as well as the highest order bit 62-2 of the register 62. The OR gates 456 and 482 and the AND gate 467 in Fig. 3 are replaced with three-input OR gates 4561 and 4821 and a three-input AND gate 4671, respectively.

When the function codes of "0" level is written into the registers 60 and 61, the AND gate 461 produces the output signal of "1" level. The flip-flop circuits 463 and 504 remain in the respective reset-states. For this reason, the selector 452 selects the register 62, the selector 502 selects the decoder circuit 480. As a result, the analog voltage signal specified by the code stored in the register 62 is repeatedly converted into the digital data, and the digital data are successively memorized in the registers 37 to 44 of Fig. 2. Moreover, the interrupt requesting signal 59 is produced upon completion of every A/D converting operation.

When the function codes of "1" level and "0" level are respectively written into the registers 60 and 61, only the AND gate 459 produces the output signal of "1" level, and the OR gate 454 produces the output signl of "0" level. The flip-flop circuit 463 produces the output signal of "0" level at the Q node thereof, and the AND gate 515 produces the output signal of "0" level. The highest order bit of the counter circuit 451 is transferred through the AND gate 513 and the OR gate 511 to the selector circuit 452. The selector 452 selects the three-bit output signal of the counter 451, and the selector 502 selects the output signal of the decoder circuit 480. the analog voltage signals on the eight input nodes are successively converted into the corresponding digital data which are transferred to the registers 37 to 44 (in Fig. 2) for memorization. When one cycle of the A/D converting operations are completed, the overflow signal 481 is supplied from the counter circuit 451, and the interrupt requesting signal 59 is fed to the central processing unit 32.

If the function codes of "0" level and "1" level are written into the registers 60 and 61, respectively, the AND gate 468 detects the write-in operation of the "1" level carried out for the register 61, and the detecting signal 70 is produced therein. The detecting signal 70 is used to shift the flip-flop circuit 463 into the set-state. However, the flip-flop circuit 504 is not shifted into the set-state due to the AND gate 508. When the flip-flop circuit 463 is shifted into the set-state, the AND gate produces the output signal of "1" level, and the OR gate 454 produces the output signal of "1" level. The selector 452 selects the register 62. THe flip-flop circuit 504 is not shifted into the set state, selector 502 selects the decoder 480. Then, the analog voltage signal indicated by the node selecting code in the register 62 is converted into the corresponding digital data bits which is transferred to the corresponding register of the register group 37 to 44 in FIg. 2. The conversion complete signal 470 is produced, and, accordingly, the interrupt requesting signal 59 takes place with the complete signal 470, because the gates 510 and 458 are opened. The complete signal 470 is further used for shifting the flip-flop circuit 463 into the reset-state, thereby allowing the OR gate 454 to produce the output signal of "0" level. As a result, the selector 452 selects the counter 469, and, for this reason, the A/D converting operations are repeatedly carried out for all of the analog input signals. However, no interrupt requesting signal takes place upon production of the overflow signal 481, because the AND gate 457 remains in the inactive state.

Finally, if the function code of "1" level is written into the registers 60 and 61, the detecting signal 70 is supplied through the AND gate 508 and the OR gate 507 to the flip-flop circuit 504 to shift into the set-state. The detecting signal 70 is further used to shift the flip-flop circuit 463 into the set-state. The OR gate 505, the AND gate 460 and the OR gate 454 respectively produces the output signals of "1" level, and the selector 452 selects the register 62 so as to transfer the contents thereof to the decoder circuit 480. If the flip-flop circuit 504 is shifted to the set-state, the selector 502 selects the second decoder 501. The decoder circuit 501 is supplied with the lower order two bits 451-0 and 451-1 and the highest order bit 62-2 of the register 62, and the counter circuit 451 is shifted into the reset-state with the A/D conversion activation signal 469. The decoder 501 is supplied with the bit string of "000" or "001" depending upon the contents of the register 62. In detail, if the node selecting code is stored in the register 62 for selecting one of the input nodes 47 to 50, the bit string "000" is supplied to the decoder 501 for specifying the register 37. However, if one of the analog inputs 51 to 54 is specified, the bit string "001" specifies the register 41. Assuming now that the contents of the register 62 specifies the analog input 49, the A/D conversion data bits are memorized in the register 37. When a single A/D converting operation is completed, the signal 470 takes place, and the counter circuit 469 is incremented by one, so that the bit string "100" is supplied to the decoder 501. The signal 470 is used for shifting the flip-flop circuit 463 into the reset-state, however, the flip-flop circuit 504 is not shifted into the reset-state, the OR gate 505 allows the OR gate 454 to produce the output signal of "1" level. Since the AND gate is not activated, the interrupt requesting signal 59 does not take place even if the signal 47 0 is supplied. Since the selector 452 continues to select the register 62, the A/D converting operation is repeated again for the analog input 49. and the corresponding digital data bits are memorized in the register 38. In the similar manner, the A/D converting operation is repeated twice for te analog input 49, and the corresponding digital data are memorized in the registers 39 and 40, respectively. With the signal 470 produced upon completion of the fourth A/D converting operation, the highest order bit 451-2 of the counter 469 becomes to be "1". The AND gate 503 is activated with the Q output of the flip-flop ciruit 504, and, for this reason, the bit 451-2 of "1" level causes to produce the interrupt requesting signal 59 which is supplied to the central processing unit 32. The output signal of the AND gate 503 is further supplied to the reset node of the flip-flop circuit 504, so that the flip-flop circuit 504 is shifted to the reset-state. The OR gate 505 produces the output signal of "0" level which allows the OR gate 454 to produce the output signal of "0" level. As a result, the selector 452 selects the counter 469. In this situation, the AND gate 515 produces the output signal of "1" level which allows the AND gate 512 to be activated. Since the AND gate 513 remains in the inactive state, the highest order bit of the register 62 is inverted and supplied to the selector 452. This results in that the bit string "001" is supplied to the selector 452, and the analog input 51 is specified. Moreover, the register 41 is selected. In this way, the A/D converting operations are sequentially carried out for the analog inputs 51 to 54. Since the output signals of the AND gates 503, 457 and 458 are logic "0" level, no interrupt requesting signal 32 takes place.

If the A/D conversion requesting signal 58 is supplied in the co-presence of the function codes of "0" level and "1" level respectively stored in the registers 60 and 61, the AND gate 4671 produces the output signal of "1" level which establish the A/D converter into the third operation mode.

If the A/D converting signal 58 is supplied in the co-presence of the function codes of "1" level stored in the registers 60 and 61, the AND gate 509 produces the output signal of "1" level to cause the A/D converter to enter the fourth operation mode.

In this instance, the A/D converter is established into one of the four modes of operation, and it is not necessary for the central processing unit 32 that the interrupt requesting signal 59 is masked and recovered therefrom.

The present invention may be applicable to a one-chip microcomputer with built-in A/D converter in which a program memory and a working memory are incorporated together with a central processing unit. In the second mixed mode of the operation, the A/D converting operation may be repeated a predetermined number of times except for four.

## Claims

1. A data processor with a built-in analog-to-digital converter comprising
a) a central processing unit (32) operative to produce a mode signal indicative of one of a scanning analog-to-digital conversion and a discrete analog-to-digital conversion.
b) a plurality of analog input nodes (47 to 54) where analog signals are respectively supplied,
c) an analog input selecting means (62) operative to select one of said analog input nodes for said discrete analog-to-digital conversion,
d) an analog-to-digital converting unit (36) operative to convert the analog signal at the analog input node selected by said analog input selecting means into a digital code in said discrete analog-to-digital conversion and to sequentially convert the analog signals at said plurality of analog input nodes into digital codes in said scanning analog-to-digital conversion,
e) a plurality of registers each operative to store said digital code, and
f) an analog-to-digital conversion activating means (60) operative to cause said analog-to-digital converting unit to selectively carry out said discrete analog-to-digital conversion and said scanning analog-to-digital conversion depending upon said mode signal,
characterized by
an automatic transition means (46/70/61) responsive to said mode signal indicative of an automatic transition from said discrete analog-to-digital conversion to said scanning analog-to-digital conversion, and operative to automatically start said scanning analog-to-digital conversion when said discrete analog-to-digital conversion is completed.

## Patentansprüche

1. Datenprozessor mit eingebautem Analog/Digital-Konverter mit
a) einer zentralen Prozessoreinheit (32), die im Betrieb ein Modussignal erzeugt, das eine Abtast-Analog/Digital-Wandlung oder eine diskrete Anolog/Digital-Wandlung anzeigt,
b) einer Vielzahl von analogen Eingangsknoten (47 bis 54), an denen jeweils analoge Signale zugeführt werden,
c) eine Analog-Eingangsauswahlvorrichtung (62), die im Betrieb einen analogen Eingangsknoten auswählt für eine diskrete Analog/Digital-Konversion,
d) eine Analog/Digital-Konvertereinheit (36), die im Betrieb das analoge Signal am Analogeingangsknoten, der durch die Analog-Eingangsauswahlvorrichtung ausgewählt wurde, in einem digitalem Code in der diskreten Analog/Digital-Konversion umwandelt und sequentiell die analogen Signale an der Vielzahl von analogen Eingangsknoten in die digitale Codes in der Abtast-Analog/Digital-Konversion umwandelt,
e) einer Vielzahl von Registern, die im Betrieb jeweils den digitalen Code speichern,
f) eine Analog/Digital-Konversions-Aktivierungsvorrichtung (60), die im Betrieb bewirkt, daß die Analog/Digital-Konvertereinheit selektiv die diskrete Analog/Digital-Konversion ausführt und die Abtast-Analog/Digital-Konversion in Abhängigkeit von dem Modussignal,
**gekennzeichnet** durch
eine automatische Übergangsvorrichtung (46/70/61), die in Antwort auf das Modussignal einen automatischen Übergang zeigt, von der diskreten Analog/Digital-Konversion zur Abtast-Analog/Digital-Konversion, und die im Betrieb automatisch die Abtast-Analog/Digital-Konversion startet, wenn die diskrete Analog/Digital-Konversion vollendet ist.

## Revendications

1. Processeur de données à convertisseur analogique-numérique intégré, comprenant :
a) une unité centrale de traitement (32) fonctionnant pour produire un signal de mode indicatif de l'une des conversion analogique-numérique de balayage et conversion analogique-numérique discrète.
b) une pluralité de noeuds d'entrée analogique (47 à 54) auxquels sont repectivement délivrés des signaux analogiques,
c) un moyen de sélection d'entrée analogique (62) fonctionnant pour sélectionner l'un desdits noeuds d'entrée analogique pour ladite conversion analogique-numérique discrète,
d) une unité de conversion analogique-numérique (36) fonctionnant pour convertir le signal analogique au noeud d'entrée analogique sélectionné par ledit moyen de sélection d'entrée analogique en un code numérique dans ladite conversion analogique-numérique discrète et pour convertir séquentiellement les signaux analogiques à ladite pluralité de noeuds d'entrée analogique en des codes numériques dans ladite conversion analogique-numérique de balayage,
e) une pluralité de registres, chacun fonctionnant pour mémoriser ledit code numérique, et
f) un moyen de déclenchement de conversion analogique-numérique (60) fonctionnant pour amener ladite unité de conversion analogique-numérique à effectuer sélectivement ladite conversion analogique-numérique discrète et ladite conversion analogique-numérique de balayage selon ledit signal de mode,
caractérisé par
un moyen de transition automatique (46/70/61) sensible audit signal de mode indicatif d'une transition automatique de ladite conversion analogique-numérique discrète à ladite conversion analogique-numérique de balayage, et fonctionnant pour commencer automatiquement ladite conversion analogique-numérique de balayage lorsque ladite conversion analogique-numérique discrète est achevée.
